# EUROPEAN PATENT APPLICATION

(11) **EP 4 535 661 A1**
(43) Date of publication of application: **09.04.2025**
(21) Application number: 23210063.6
(22) Date of filing: 15.11.2023
(51) Int. Cl.: H03F 1/32, H03F 3/195, H03F 3/21, H03F 3/45

(54) **MULTI-GATE DIFFERENTIAL POWER AMPLIFIER**

(30) Priority: 02.10.2023 US 202318479139
(71) Applicant: GlobalFoundries U.S. Inc., Malta, NY 12020 (US)
(72) Inventor: Bellaouar, Abdellatif, Richardson, 75082 (US); Syed, Shafiullah, Richardson, 75094 (US)
(74) Representative: Grünecker Patent- und Rechtsanwälte PartG mbB

(57) **Abstract**

A differential power amplifier circuit (100), including: a first differential power amplifier (102) including first and second cross-coupled neutralization capacitors; and a second differential power amplifier (104), coupled in parallel with the first differential power amplifier (102), including a plurality of multi-gate transistors (106).

## Description

### BACKGROUND

The present disclosure relates to integrated circuits and, more particularly, to a multi-gate differential power amplifier.

Power amplifiers are used in a number of integrated circuit applications. For example, power amplifiers are typically included in wireless communication devices such as cellular phones, two-way radios, etc. One type of power amplifier is a differential power amplifier, which is configured to amplify the difference between two input signals and reject any common signals.

### SUMMARY

Aspects of the disclosure include a differential power amplifier circuit, including: a first differential power amplifier including first and second cross-coupled neutralization capacitors; and a second differential power amplifier, coupled in parallel with the first differential power amplifier, including a plurality of multi-gate transistors.

Aspects of the disclosure further include differential power amplifier circuit, including: a first differential power amplifier including first and second parallel branches, wherein the first differential power amplifier includes first and second neutralization capacitors cross-coupled between the first and second parallel branches; and a second, multi-gate differential power amplifier including first and second parallel branches, wherein the first and second parallel branches of the second differential power amplifier are coupled to the first and second parallel branches, respectively, of the first differential power amplifier.

Aspects of the disclosure further include a radio frequency (RF) differential power amplifier circuit, including: an RF input stage for receiving an RF input signal; a first differential power amplifier including first and second parallel branches coupled to the RF input stage, wherein the first differential power amplifier includes first and second neutralization capacitors cross-coupled between the first and second parallel branches; a second, multi-gate differential power amplifier including first and second parallel branches coupled to the RF input stage, wherein the first and second parallel branches of the second differential power amplifier are coupled to the first and second parallel branches, respectively, of the first differential power amplifier; and an RF output stage coupled to the first and second differential power amplifiers for outputting an amplified RF signal.

### BRIEF DESCRIPTION OF THE DRAWINGS

The present disclosure will be better understood from the following detailed description with reference to the drawings, which are not necessarily drawn to scale. In the drawings, like reference numerals refer to like features in the various views.
FIG. 1 depicts a conventional differential power amplifier in a radio frequency (RF) environment.
FIG. 2 depicts a conventional differential power amplifier in an RF environment including cross-coupled neutralizing transistors.
FIG. 3 depicts a conventional dual-gate implementation of a single-ended power amplifier.
FIGS. 4 and 5 depict a dual-gate differential power amplifier circuit according to embodiments of the disclosure.

### DETAILED DESCRIPTION

The disclosure will now be described with reference to a multi-gate differential power amplifier. While the disclosure will be described hereinafter in connection with specific devices and methods thereof, it will be understood that limiting the disclosure to such specific devices and methods is not intended. On the contrary, it is intended to cover all alternatives, modifications, and equivalents as may be included within the spirit and scope of the disclosure as defined by the appended claims.

For a general understanding of the features of the disclosure, reference is made to the drawings. The drawings are not to scale; however, in the drawings, like reference numerals have been used throughout to identify identical elements.

It will be readily understood that the devices and methods of the present disclosure, as generally described and illustrated in the drawings herein, may be arranged and designed in a wide variety of different configurations in addition to the devices and methods described herein. Thus, the following detailed description of the devices and methods, as represented in the drawings, is not intended to limit the scope defined by the appended claims but is merely representative of selected devices and methods. The following description is intended only by way of example, and simply illustrates certain concepts of the devices and methods, as disclosed and claimed herein.

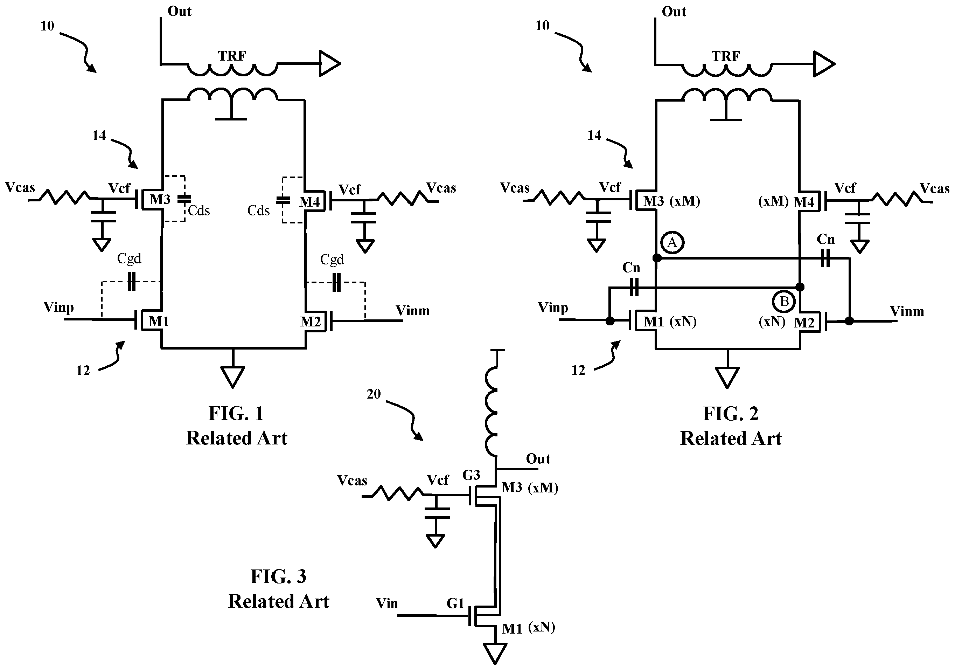

A conventional differential power amplifier 10 in a radio frequency (RF) environment is depicted in FIG. 1. Such a differential power amplifier 10 may be used, for example, in a wireless transmitter.

The differential power amplifier 10 includes a driver stage 12 including a pair of common-source transistors M1, M2 and a power stage 14 including a pair of common-gate transistors M3, M4. The common-source transistors M1, M2 each include parasitic gate to drain capacitances Cgd and the common-gate transistors M3, M4 include parasitic drain to source capacitances Cds. In the configuration shown, the differential power amplifier 10 is not stable due to the parasitic capacitances Cds and Cgs.

One technique for improving the operation of the differential power amplifier 10 is depicted in FIG. 2. In particular, the gain and stability of the differential power amplifier 10 may be improved by cancelling the effects of the parasitic capacitances Cgd using cross-coupled neutralizing capacitors Cn. As shown, a first neutralizing capacitor Cn may be coupled between the gate of the drive transistor M1 and a node (node B) between the drive transistor M2 and the power transistor M4. A second neutralizing capacitor Cn may be coupled to a node between the gate of the drive transistor M2 and a node (node A) between the drive transistor M1 and the power transistor M3.

Each of the transistors M1, M2 in the driver stage 12 of the differential power amplifier 10 may be implemented using a plurality of N power cells. Similarly, each of the transistors M3, M4 in the power stage 14 of the differential power amplifier 10 may be implemented using a plurality of M power cells. To this extent, the differential power amplifier 10 may be implemented using a total of 2 x (M + N) power cells. In general, M ≥ N. As known in the art, each power cell may include one or more power transistors designed to improve efficiency, linearity, output, and cost of a power amplifier. The transistors in the power cells may be connected in series (e.g., stacked) to provide each of the transistors M1-M4.

A multi-gate (e.g., dual-gate) implementation has been used to provide transistors in single-ended power amplifiers to reduce parasitic capacitances and hence improve the Psat (saturation output power)/PAE (power added efficiency) of the single-ended power amplifier. An example of a single-ended power amplifier 20 including a dual gate implementation merging a transistor M1 (with gate G1) and a transistor M3 (with gate G3) is depicted in FIG. 3. Merging, as described herein, refers to the merging of source and drain diffusion regions of a plurality of stacked transistors, leading to a single effective transistor with multiple gate regions.

A multi-gate implementation cannot be used in a differential power amplifier such as the differential power amplifier 10 depicted in FIG. 2. Specifically, if the transistors M1, M3 of the differential power amplifier 10 were merged using a dual-gate implementation and the transistors M2, M4 were likewise merged using a dual-gate implementation, access to nodes A and B would no longer be available, therefore preventing connection of the neutralization capacitors Cn as shown in FIG. 2. To this extent, a multi-gate (e.g., dual-gate) implementation of a differential power amplifier has yet to be developed.

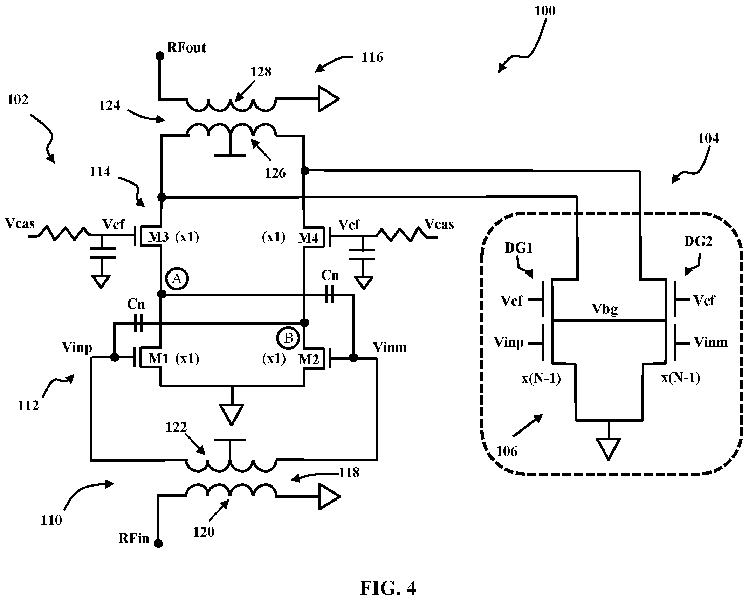

A multi-gate (hereafter "dual-gate") differential power amplifier circuit 100 according to embodiments of the disclosure is depicted in FIG. 4. As shown, the dual-gate differential power amplifier circuit 100 includes a first differential power amplifier 102, which includes cross-coupled neutralization capacitors Cn, connected in parallel to a second differential power amplifier 104, implemented using a multi-gate (hereafter "dual-gate") transistor array 106. It should be understood that the dual-gate differential power amplifier circuit 100 may be configured to operate within the radio frequency (RF) band (i.e., 3 kHz to 300 GHz) and can, for example, be configured to operate within the millimeter wave (mmWave) band thereof (e.g., 30 GHz-300 GHz).

The first differential power amplifier 102 includes multiple stages. These stages may include, but are not limited to; a radio frequency (RF) input stage 110, a driver stage 112, a power stage 114, and an RF output stage 116. For example, as described in further detail below, the driver stage 112 may include a pair of common-source transistors M1, M2 (hereafter referred to as drive transistors M1, M2) and the power stage 114 may include first and second common-gate transistors M3, M4 (hereafter referred to as power transistors M3, M4) connected in series with the drive transistors M1, M2, respectively, in the driver stage. To this extent, the first differential power amplifier 102 includes two parallel branches, each including a drive transistor and a power transistor, between the RF input stage 110 and the RF output stage 116.

The RF input stage 110 may be configured to receive an RF input signal at an RF input node RFin and the RF output stage 116 may be configured to provide impedance matching for the RF output signal at an RF output node RFout. The driver stage 112 may be connected between the RF input stage 110 and the power stage 114 and may, for example, be configured to regulate current flow through the first differential power amplifier 102 of the dual-gate differential power amplifier circuit 100.

Within a transistor, the semiconductor (or channel region) is positioned between a conductive "source" region and a similarly conductive "drain" region and when the semiconductor is in a conductive state, the semiconductor allows electrical current to flow between the source and drain. A "gate" is a conductive element that is electrically separated from the semiconductor by a "gate dielectric" and current/voltage within the gate changes the conductivity of the channel region of the transistor. The transistors M1, M2 in the driver stage 112 and the transistors M3, M4 in the power stage may be n-type field effect transistors. In some embodiments, the transistors M1-M4 in the first differential power amplifier 102 may be implemented using advanced semiconductor-on-insulator processing technology platforms (e.g., a fully-depleted semiconductor-on-insulator (FDSOI) technology platform).

Those skilled in the art will recognize that FDSOI is a planar process technology that uses an ultra-thin layer of insulator, called a buried oxide, positioned on top of the base silicon. A very thin optionally un-doped silicon film implements the transistor channel. The details of FDSOI transistors are omitted herefrom to allow the reader to focus on the salient aspects of the systems and methods described herein. Alternatively, the first differential power amplifier 102 could be implemented in any other suitable technology platform.

The power stage 114 may be connected between the driver stage 112 and the RF output stage 116 and may, for example, be configured to amplify the RF input signal, converting it from a lower power RF signal to a higher power RF signal. The RF output stage 116 may be connected to the power stage 114 and may, for example, be configured to receive and output the higher power output signal.

The RF input stage 110 may include an RF input node for receiving an RF input signal at an RF input node RFin. The RF input stage 110 may further include, for example, an RF input transformer 118 to match the input impedance of the RF input stage to that of a preceding stage. The input transformer 118 may include two magnetically coupled input windings 120, 122. The input winding 120 may include a first terminal electrically connected to the RF input node RFin. The second, opposite terminal of the input winding 120 may be electrically connected to ground, as illustrated, such that the input transformer 118 is a balun (i.e., a balanced-to-unbalanced signal conversion-type transformer). In other embodiments, the second, opposite terminal of the input winding 120 may be connected to a negative of a differential input instead of ground (not shown). A first terminal of the input winding 122 may be electrically connected to the gate of the drive transistor M1 to provide a positive input voltage Vinp to the gate of the drive transistor M1. A second terminal of the input winding 122 may be electrically connected to the gate of the drive transistor M2 to provide a negative input voltage Vinm to the gate of the drive transistor M2. The center tap of the input winding may be used to bias the drive transistors M1, M2.

The RF output stage 116 may include an RF output node RFout for outputting an amplified RF signal. The RF output stage 116 may further include, for example, an RF output transformer 124 including two magnetically coupled output windings 126, 128. The output winding 128 may have one terminal electrically connected to the RF output node RFout and the opposite terminal electrically connected to ground, as illustrated. First and second terminals of the output winding 126 may be electrically connected to a source/drain region (e.g., a drain region in the case of NFET drive transistors) of the power transistors M3, M4, respectively.

In the driver stage 112, each drive transistor M1, M2 includes a gate electrically connected to the input stage 110 as detailed above. A source/drain region (e.g., a source region in the case of NFET drive transistors) of each drive transistor M1, M2 is electrically connected to ground. A source/drain region (e.g., a drain region in the case of NFET drive transistors) of the drive transistor M1 is electrically connected in series to a source/drain region (e.g., a source region in the case of NFET drive transistors) of the power transistor M3. Similarly, a source/drain region (e.g., a drain region in the case of NFET drive transistors) of the drive transistor M2 is electrically connected in series to a source/drain region (e.g., a source region in the case of NFET drive transistors) of the power transistor M4.

In the power stage 116, a voltage Vcas is passed through an RC network 130 to provide a bias voltage Vcf, which is applied to the gate of each power transistor M3, M4. Further, as detailed above, a source/drain region (e.g., a source region in the case of NFET drive transistors) of the power transistors M3, M4 is electrically connected to a source/drain region (e.g., a drain region in the case of NFET drive transistors) of the drive transistors M1, M2, respectively. Also, as detailed above, a source/drain region (e.g., a drain region in the case of NFET drive transistors) of the power transistors M3, M4 may be electrically connected to first and second terminals, respectively, of the output winding 126 of the RF output stage 116.

A first neutralizing capacitor Cn may be coupled between the gate of the drive transistor M1 and a node (node B) between the drive transistor M2 and the power transistor M4. A second neutralizing capacitor Cn may be coupled between the gate of the drive transistor M2 and a node (node A) between the drive transistor M1 and the power transistor M3. The neutralization capacitors Cn are used to cancel the parasitic gate-to-drain capacitance Cgd of the drive transistors M1, M2 and improve the reverse isolation, power gain, and stability of the dual-gate differential power amplifier circuit 100.

As further depicted in FIG. 4, the dual-gate transistor array 106 includes a first dual-gate transistor DG1 (merging the drive transistor M1 and the power transistor M3) in a first parallel branch and a second dual-gate transistor DG2 (merging the drive transistor M2 and the power transistor M4) in a second parallel branch. As shown, a source/drain region (e.g., a source region in the case of NFET drive transistors) of the first and second dual-gate transistors DG1, DG2 are electrically connected to ground. Further, a source/drain region (e.g., a drain region in the case of NFET drive transistors) of the first dual-gate transistor DG1 is electrically connected to a node between the source/drain region (e.g., a drain region in the case of NFET drive transistors) of the power transistor M3 in the first differential power amplifier 102 and the output stage 116. Similarly, a source/drain region (e.g., a drain region in the case of NFET drive transistors) of the second dual-gate transistor DG2 is electrically connected to a node between a source/drain region (e.g., a drain region in the case of NFET drive transistors) of the power transistor M4 in the first differential power amplifier 102 and the output stage 116. A first gate of the first dual-gate transistor DG1 is gated by the positive input voltage Vinp (e.g., from the input stage 110). A first gate of the second dual-gate transistor DG2 is gated by the negative input voltage Vinm (e.g., from the input stage 110). The bias voltage Vcf (e.g., from the input stage 110) is applied to a second gate of the first dual-gate transistor DG1 and a second gate of the second dual-gate transistor DG2. The back-gates of the first and second dual-gate transistors DG1, DG2 are biased at a voltage Vbg. The first and second dual-gate transistors DG1, DG2 reduce parasitic capacitances and hence improve the Psat (saturation output power)/PAE (power added efficiency) of the dual-gate power amplifier circuit 100.

Referring temporarily to FIG. 2, it can be seen that a total of 2 x (M + N) power cells may be used to implement the transistors M1-M4 in the differential power amplifier 10. For example, if N = M = 12, then a total of 48 power cells would be required to implement the differential power amplifier 10.

According to embodiments of the disclosure, the transistors M1-M4 in the first differential power amplifier 102 and the dual-gate transistors DG1, DG2 in the second differential power amplifier 104 may be implemented using a total of 2 x (M + N) power cells. Examples of the allocation of the 2 x (M + N) power cells between the first differential power amplifier 102 and the second differential power amplifier 104 in the dual-gate differential power amplifier circuit 100 are provided below.

In a first example, as depicted in FIG. 4, it is assumed that N = M. In this case, the second differential power amplifier 104 may be implemented using N - 1 dual-gate transistors DG1 in series in a first parallel branch and N - 1 dual-gate transistors DG2 in series in a second parallel branch, where each dual-gate transistor DG1, DG2 requires 2 power cells that are merged into 1 merged power cell. Assuming again that N = 12, then (N - 1) = (12 - 1) = 11, a total of 11 merged power cells may be used to implement the dual-gate transistor DG1. Likewise, a total of 11 merged power cells may be used to implement the dual-gate transistor DG2. Further, each transistor M1-M4 in the first differential power amplifier 102 may be implemented using 1 power cell.

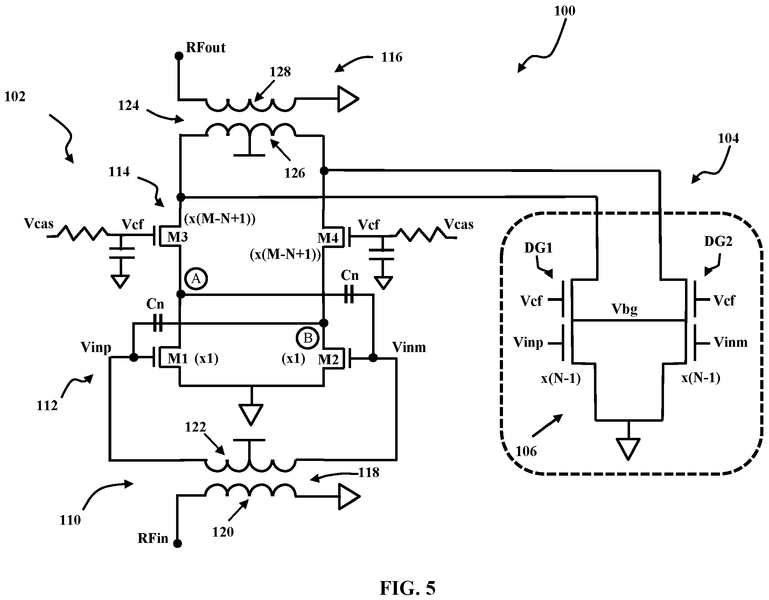

In a second example, as depicted in FIG. 5, it is assumed that N ≠ M (typically M > N). Similar to the M = N example, the second differential power amplifier 104 may be implemented using N - 1 dual-gate transistors DG1 in series in a first parallel branch and N - 1 dual-gate transistors DG2 in series in a second parallel branch, where each dual-gate transistor DG1, DG2 requires 2 power cells that are merged into 1 merged power cell. Assuming that N = 12 and M = 14, then (N - 1) = (12 - 1) = 11, a total of 11 merged power cells may be used to implement each dual-gate transistor DG1, DG2. In the first differential power amplifier 102, each power transistor M3, M4 may be implemented, for example, using a total of (M - N + 1) = (14 - 12 + 1) = 3 power cells and each drive transistor M1, M2 may be implemented using 1 power cell.

The neutralization capacitors Cn in the first differential power amplifier 102 of the dual-gate differential power amplifier circuit 100 cancel the parasitic gate-to-drain capacitance Cgd of the drive transistors M1, M2 and the parasitic gate-to-drain capacitance Cgd of DG1 and DG2 and improve the reverse isolation, power gain, and stability of the dual-gate differential power amplifier circuit 100. Further, the dual-gate transistors DG1, DG2 in the second differential power amplifier 104 of the dual-gate differential power amplifier circuit 100 reduce parasitic capacitances and hence improve the Psat/PAE of the dual-gate power amplifier circuit 100. According to embodiments, the performance of the dual-gate differential power amplifier circuit 100 is dominated by the N-1 array parasitic. For example, the drain-source node between the common source and common gate in the dual gate transistor DG1 and the common source and common gate in the dual gate transistor DG2 has a lower parasitic capacitance than the corresponding transistors M1-M4 in the first differential power amplifier 102. Since, as detailed above, most of the power cells may be used to implement the dual gate transistors DG1 and DG2, the global intermediate node capacitance is therefore reduced greatly, hence providing higher Psat and PAE.

It should be understood that the terminology used herein is for the purpose of describing the disclosed structures and methods and is not intended to be limiting. For example, as used herein, the singular forms "a," "an," and "the" are intended to include the plural forms as well, unless the context clearly indicates otherwise. Additionally, as used herein, the terms "comprises," "comprising," "includes," and/or "including" specify the presence of stated features, integers, steps, operations, elements, and/or components, but do not preclude the presence or addition of one or more other features, integers, steps, operations, elements, components, and/or groups thereof. Furthermore, as used herein, terms such as "right," "left," "vertical," "horizontal," "top," "bottom," "upper," "lower," "under," "below," "underlying," "over," "overlying," "parallel," "perpendicular," etc., are intended to describe relative locations as they are oriented and illustrated in the drawings (unless otherwise indicated) and terms such as "touching," "in direct contact," "abutting," "directly adjacent to," "immediately adjacent to," etc., are intended to indicate that at least one element physically contacts another element (without other elements separating the described elements). The term "laterally" is used herein to describe the relative locations of elements and, more particularly, to indicate that an element is positioned to the side of another element as opposed to above or below the other element, as those elements are oriented and illustrated in the drawings. For example, an element that is positioned laterally adjacent to another element will be beside the other element, an element that is positioned laterally immediately adjacent to another element will be directly beside the other element, and an element that laterally surrounds another element will be adjacent to and border the outer sidewalls of the other element. The corresponding structures, materials, acts, and equivalents of all means or step plus function elements in the claims below are intended to include any structure, material, or act for performing the function in combination with other claimed elements as specifically claimed.

References herein to terms modified by language of approximation, such as "about," "approximately," and "substantially," are not to be limited to the precise value specified. The language of approximation may correspond to the precision of an instrument used to measure the value and, unless otherwise dependent on the precision of the instrument, may indicate +/-10% of the stated value(s).\

References herein to terms such as "vertical," "horizontal," etc. are made by way of example, and not by way of limitation, to establish a frame of reference. The term "horizontal" as used herein is defined as a plane parallel to a conventional plane of a semiconductor substrate, regardless of its actual three-dimensional spatial orientation. The terms "vertical" and "normal" refer to a direction perpendicular to the horizontal, as just defined. The term "lateral" refers to a direction within the horizontal plane.

A feature "connected" or "coupled" to or with another feature may be directly connected or coupled to or with the other feature or, instead, one or more intervening features may be present. A feature may be "directly connected" or "directly coupled" to or with another feature if intervening features are absent. A feature may be "indirectly connected" or "indirectly coupled" to or with another feature if at least one intervening feature is present. A feature "on" or "contacting" another feature may be directly on or in direct contact with the other feature or, instead, one or more intervening features may be present. A feature may be "directly on" or "in direct contact with" another feature if intervening features are absent. A feature may be "indirectly on" or "in indirect contact with" another feature if at least one intervening feature is present.

The descriptions of the various embodiments of the present disclosure have been presented for purposes of illustration, but are not intended to be exhaustive or limited to the embodiments disclosed. Many modifications and variations will be apparent to those of ordinary skill in the art without departing from the scope and spirit of the described embodiments. The terminology used herein was chosen to best explain the principles of the embodiments, the practical application or technical improvement over technologies found in the marketplace, or to enable others of ordinary skill in the art to understand the embodiments disclosed herein.

In summary, a differential power amplifier circuit is disclosed, the differential power amplifier comprising a first differential power amplifier comprising first and second cross-coupled neutralization capacitors, and a second differential power amplifier. The second differential power amplifier is coupled in parallel with the first differential power amplifier, comprising a plurality of multi-gate transistors.

The following embodiments are explicitly disclosed.

### Embodiment 1:

A differential power amplifier circuit, comprising:
a first differential power amplifier including first and second cross-coupled neutralization capacitors; and
a second differential power amplifier, coupled in parallel with the first differential power amplifier, including a plurality of multi-gate transistors.

### Embodiment 2:

The differential power amplifier circuit according to embodiment 1, wherein the multi-gate transistors comprise dual-gate transistors.

### Embodiment 3:

The differential power amplifier circuit according to embodiment 1 or 2, wherein the first differential power amplifier includes:
an input stage;
an output stage; and
first and second parallel branches connected between the input stage and the output stage, wherein each of the first and second parallel branches includes a drive transistor and a power transistor connected in series between the input stage and the output stage, wherein a gate of the drive transistor is connected to the input stage and wherein the gate of the power transistor is connected to a bias voltage.

### Embodiment 4:

The differential power amplifier circuit according to embodiment 3, wherein the first cross-coupled neutralization capacitor is coupled between the gate of the drive transistor in the first parallel branch and a node between the drive transistor and the power transistor in the second parallel branch, and wherein the second cross-coupled neutralization capacitor is coupled between the gate of the drive transistor in the second parallel branch and a node between the drive transistor and the power transistor in the first parallel branch.

### Embodiment 5:

The differential power amplifier circuit according to embodiment 3 or 4, wherein the input stage includes:
an input node; and
an input transformer including two magnetically coupled input windings, wherein one of the input windings is connected between the input node and any of ground and another input node, and wherein another of the input windings is connected at opposite ends to the gates of the drive transistors in the first and second parallel branches, respectively.

### Embodiment 6:

The differential power amplifier circuit according to one of embodiments 3 to 5, wherein the second differential power amplifier includes:
first and second parallel branches, wherein each of the first and second branches of the second differential power amplifier includes a multi-gate transistor, wherein a first gate of the multi-gate transistor is connected to the input stage of the first differential power transistor, and wherein a second gate of the multi-gate transistor is connected to the bias voltage.

### Embodiment 7:

The differential power amplifier circuit according to one of embodiments 3 to 6, wherein the multi-gate transistor in the first parallel branch of the second differential power amplifier is connected between ground and a node between the power transistor in the first parallel branch of the first differential power amplifier and the output stage, and wherein the multi-gate transistor in the second parallel branch of the second differential power amplifier is connected between ground and a node between the power transistor in the second parallel branch of the first differential power amplifier and the output stage.

### Embodiment 8:

The differential power amplifier circuit according to one of embodiments 1 to 7, wherein the differential power amplifier circuit is implemented using a plurality of X power cells.

### Embodiment 9:

The differential power amplifier circuit according to embodiment 8, wherein each drive transistor and each power transistor in the first differential power amplifier is implemented using 1 power cell, and wherein each dual-gate transistor in the second differential power amplifier is implemented using (X-4)/4 merged power cells.

### Embodiment 10:

The differential power amplifier circuit according to embodiment 8 or 9, wherein each drive transistor in the first differential power amplifier is implemented using 1 power cell, each power transistor in the first differential power amplifier is implemented using 3 power cells, and wherein each dual-gate transistor in the second differential power amplifier is implemented using (X-8)/4 merged power cells.

### Embodiment 11:

A differential power amplifier circuit, comprising:
a first differential power amplifier including first and second parallel branches, wherein the first differential power amplifier includes first and second neutralization capacitors cross-coupled between the first and second parallel branches; and
a second, multi-gate differential power amplifier including first and second parallel branches, wherein the first and second parallel branches of the second differential power amplifier are coupled to the first and second parallel branches, respectively, of the first differential power amplifier.

### Embodiment 12:

The differential power amplifier circuit according to embodiment 11, wherein the first differential power amplifier includes:
an input stage; and
an output stage;
wherein the first and second parallel branches are connected between the input stage and the output stage, wherein each of the first and second parallel branches includes a drive transistor and a power transistor connected in series between the input stage and the output stage, wherein a gate of the drive transistor is connected to the input stage and wherein the gate of the power transistor is connected to a bias voltage.

### Embodiment 13:

The differential power amplifier circuit according to embodiment 11 or 12, wherein the first cross-coupled neutralization capacitor is coupled between the gate of the drive transistor in the first parallel branch and a node between the drive transistor and the power transistor in the second parallel branch, and wherein the second cross-coupled neutralization capacitor is coupled between the gate of the drive transistor in the second parallel branch and a node between the drive transistor and the power transistor in the first parallel branch.

### Embodiment 14:

The differential power amplifier circuit according to one of embodiments 11 to 13, wherein the input stage includes:
an input node; and
an input transformer including two magnetically coupled input windings, wherein one of the input windings is connected between the input node and any of ground and another input node, and wherein another of the input windings is connected at opposite ends to the gates of the drive transistors in the first and second parallel branches, respectively.

### Embodiment 15:

The differential power amplifier circuit according to one of embodiments 11 to 14, wherein each of the first and second parallel branches of the second, multi-gate differential power amplifier includes a multi-gate transistor, wherein a first gate of the multi-gate transistor is connected to the input stage of the first differential power transistor, and wherein a second gate of the multi-gate transistor is connected to the bias voltage.

### Embodiment 16:

The differential power amplifier circuit according to one of embodiments 11 to 15, wherein the multi-gate transistor in the first parallel branch of the second differential power amplifier is connected between ground and a node between the power transistor in the first parallel branch of the first differential power amplifier and the output stage, and wherein the multi-gate transistor in the second parallel branch of the second differential power amplifier is connected between ground and a node between the power transistor in the second parallel branch of the first differential power amplifier and the output stage.

### Embodiment 17:

The differential power amplifier circuit according to one of embodiments 11 to 16, wherein the differential power amplifier circuit is implemented using a plurality of X power cells.

### Embodiment 18:

The differential power amplifier circuit according to embodiment 17, wherein each drive transistor and each power transistor in the first differential power amplifier is implemented using 1 power cell, and wherein each dual-gate transistor in the second differential power amplifier is implemented using (X-4)/4 merged power cells.

### Embodiment 19:

The differential power amplifier circuit according to embodiment 17 or 18, wherein each drive transistor in the first differential power amplifier is implemented using 1 power cell, each power transistor in the first differential power amplifier is implemented using 3 power cells, and wherein each dual-gate transistor in the second differential power amplifier is implemented using (X-8)/4 merged power cells.

### Embodiment 20:

A radio frequency (RF) differential power amplifier circuit, comprising:
an RF input stage for receiving an RF input signal;
a first differential power amplifier including first and second parallel branches coupled to the RF input stage, wherein the first differential power amplifier includes first and second neutralization capacitors cross-coupled between the first and second parallel branches;
a second, multi-gate differential power amplifier including first and second parallel branches coupled to the RF input stage, wherein the first and second parallel branches of the second differential power amplifier are coupled to the first and second parallel branches, respectively, of the first differential power amplifier; and
an RF output stage coupled to the first and second differential power amplifiers for outputting an amplified RF signal.

### Embodiment 21:

The RF differential power amplifier circuit according to embodiment 20 may be combined with each of embodiments 1 to 19 in that the differential power amplifier circuit according to any of embodiments 1 to 19 may be considered as further comprising: an RF input stage for receiving an RF input signal; and an RF output stage coupled to the first and second differential power amplifiers for outputting an amplified RF signal. The first and second parallel branches of the first differential power amplifier may be coupled to the RF input stage. The first and second parallel branches of the second differential power amplifier may be coupled to the RF input stage.

At least in the embodiments above, the term "include" and its variants may be interpreted as meaning that an embodiment includes stated features, while not necessarily excluding the presence of other features that are not explicitly stated.

## Claims

1. A differential power amplifier circuit, comprising:
a first differential power amplifier comprising first and second cross-coupled neutralization capacitors; and
a second differential power amplifier comprising a plurality of multi-gate transistors,
wherein the second differential power amplifier is preferably coupled in parallel with the first differential power amplifier.

2. The differential power amplifier circuit according to claim 1, wherein the multi-gate transistors comprise dual-gate transistors.

3. The differential power amplifier circuit according to claim 1 or 2,
wherein the first differential power amplifier comprises first and second parallel branches, wherein the first and second neutralization capacitors are cross-coupled between the first and second parallel branches, and
wherein the second differential power amplifier comprises first and second parallel branches, wherein the first and second parallel branches of the second differential power amplifier are coupled to the first and second parallel branches, respectively, of the first differential power amplifier.

4. The differential power amplifier circuit according to claim 3, further comprising:
an RF input stage for receiving an RF input signal; and
an RF output stage coupled to the first and second differential power amplifiers for outputting an amplified RF signal,
wherein the first and second parallel branches of the first differential power amplifier are coupled to the RF input stage, and
wherein the first and second parallel branches of the second differential power amplifier are coupled to the RF input stage.

5. The differential power amplifier circuit according to claim 3 or 4, wherein the first differential power amplifier comprises:
an input stage; and
an output stage;
wherein the first and second parallel branches are connected between the input stage and the output stage, wherein each of the first and second parallel branches comprises a drive transistor and a power transistor connected in series between the input stage and the output stage, wherein a gate of the drive transistor is connected to the input stage and wherein the gate of the power transistor is connected to a bias voltage.

6. The differential power amplifier circuit according to claim 1 or 2, wherein the first differential power amplifier comprises:
an input stage;
an output stage; and
first and second parallel branches connected between the input stage and the output stage, wherein each of the first and second parallel branches comprises a drive transistor and a power transistor connected in series between the input stage and the output stage, wherein a gate of the drive transistor is connected to the input stage and wherein the gate of the power transistor is connected to a bias voltage.

7. The differential power amplifier circuit according to claim 5 or 6, wherein the first cross-coupled neutralization capacitor is coupled between the gate of the drive transistor in the first parallel branch and a node between the drive transistor and the power transistor in the second parallel branch, and wherein the second cross-coupled neutralization capacitor is coupled between the gate of the drive transistor in the second parallel branch and a node between the drive transistor and the power transistor in the first parallel branch.

8. The differential power amplifier circuit according to one of claims 5 to 7, wherein the input stage comprises:
an input node; and
an input transformer comprising two magnetically coupled input windings, wherein one of the input windings is connected between the input node and any of ground and another input node, and wherein another of the input windings is connected at opposite ends to the gates of the drive transistors in the first and second parallel branches, respectively.

9. The differential power amplifier circuit according to one of claims 5 to 8, wherein the second differential power amplifier comprises:
first and second parallel branches, wherein each of the first and second branches of the second differential power amplifier comprises a multi-gate transistor, wherein a first gate of the multi-gate transistor is connected to the input stage of the first differential power transistor, and wherein a second gate of the multi-gate transistor is connected to the bias voltage.

10. The differential power amplifier circuit according to claim 9 in combination with claim 6, further comprising:
an RF input stage for receiving an RF input signal; and
an RF output stage coupled to the first and second differential power amplifiers for outputting an amplified RF signal,
wherein the first and second parallel branches of the first differential power amplifier are coupled to the RF input stage, and
wherein the first and second parallel branches of the second differential power amplifier are coupled to the RF input stage.

11. The differential power amplifier circuit according to one of claims 3 to 10, wherein the multi-gate transistor in the first parallel branch of the second differential power amplifier is connected between ground and a node between the power transistor in the first parallel branch of the first differential power amplifier and the output stage, and wherein the multi-gate transistor in the second parallel branch of the second differential power amplifier is connected between ground and a node between the power transistor in the second parallel branch of the first differential power amplifier and the output stage.

12. The differential power amplifier circuit according to one of claims 1 to 11, wherein the differential power amplifier circuit is implemented using a plurality of X power cells.

13. The differential power amplifier circuit according to claim 12 in combination with one of claims 4 to 6, wherein each drive transistor and each power transistor in the first differential power amplifier is implemented using one power cell, and wherein each dual-gate transistor in the second differential power amplifier is implemented using (X-4)/4 merged power cells.

14. The differential power amplifier circuit according to claim 12 or 13 in combination with one of claims 4 to 6, wherein each drive transistor in the first differential power amplifier is implemented using one power cell, each power transistor in the first differential power amplifier is implemented using three power cells, and wherein each dual-gate transistor in the second differential power amplifier is implemented using (X-8)/4 merged power cells.

15. A radio frequency (RF) differential power amplifier circuit, comprising:
an RF input stage for receiving an RF input signal;
a first differential power amplifier comprising first and second parallel branches coupled to the RF input stage, wherein the first differential power amplifier comprises first and second neutralization capacitors cross-coupled between the first and second parallel branches;
a second, multi-gate differential power amplifier comprising first and second parallel branches coupled to the RF input stage, wherein the first and second parallel branches of the second differential power amplifier are coupled to the first and second parallel branches, respectively, of the first differential power amplifier; and
an RF output stage coupled to the first and second differential power amplifiers for outputting an amplified RF signal.
